# EUROPÄISCHE PATENTSCHRIFT

(11) **EP 1 686 597 B1**
(45) Veröffentlichungstag und Bekanntmachung des Hinweises auf die Patenterteilung: **05.10.2016**
(21) Anmeldenummer: 05112355.2
(22) Anmeldetag: 19.12.2005
(51) Int. Cl.: H01F 38/14, H05K 13/04

(54) **Vorrichtung zur induktiven Energieübertragung zwischen einem Bestückautomaten und einer Zuführeinrichtung für Bauelemente, Zuführeinrichtung und Bestückautomat.**
Device for inductive energy transfer between a component placement unit and a component feeding unit for components; component placement unit and component feeding unit
Dispositif de transfert d'énergie par induction entre une unité de placement de composants et une unité de fourniture de composant; unité de placement de composants et une unité de fourniture de composants

(30) Priorität: 04.01.2005 DE 102005000744
(43) Veröffentlichungstag der Anmeldung: 02.08.2006
(73) Patentinhaber: ASM Assembly Systems GmbH & Co. KG, 81379 München (DE)
(72) Erfinder: Eschenweck, Friedrich, 85622 Feldkirchen (DE); Liebeke, Thomas, 85521 Ottobrunn (DE); Pallas, Dirk, 86899 Landsberg (DE)
(74) Vertreter: Patentanwälte Bals & Vogel

(56) Entgegenhaltungen:
- DE-B1- 2 434 890
- JP-A- 9 307 283
- JP-A- 2003 142 327
- JP-A- 2004 022 779
- US-A- 4 929 005

## Beschreibung

Vorrichtung zur induktiven Energieübertragung zwischen einem Bestückautomaten und einer Zuführeinrichtung für Bauelemente, Zuführeinrichtung und Bestückautomat.

Die vorliegende Erfindung betrifft eine Vorrichtung zur induktiven Energieübertragung zwischen einem Bestückautomaten und einer Zuführeinrichtung für Bauelemente, eine Zuführeinrichtung sowie einen Bestückautomaten.

In Bestückautomaten werden Substrate mit elektrischen Bauelementen bestückt. Ein über einem Arbeitsfeld des Bestückautomaten beweglicher Bestückkopf nimmt die elektrischen Bauelemente an einer Abholposition auf und transportiert diese zu einer Bestückposition, wo die Substrate bestückt werden. Die Bereitstellung der Bauelemente an der Abholposition geschieht mittels mehrerer Zuführeinrichtungen, die meist seitlich entlang der Bestückstrecke am Bestückautomaten angekoppelt sind. Die Zuführeinrichtungen sind mit Bauelementen, z.B. in Form von Bauelementgurten, aufmagaziniert. Jede Zuführeinrichtung verfügt über eine eigene Transportmechanik mit meist elektrischem Antrieb, die den Vorschub der Bauteilgurte vornimmt. Die dafür notwendige elektrische Energie wird meist vom Bestückautomaten bereitgestellt.

Aus der Offenlegungsschrift EP-0453370 ist eine derartige Zuführeinrichtung für Bauelemente für einen Bestückautomaten bekannt, die beim Anbringen an den Bestückautomaten mittels einer externen Steckerverbindung mit der auf Seiten des Bestückautomaten liegenden Stromversorgung elektrisch verbunden wird. Die JP 9 307283 zeigt grundsätzlich eine induktive Übertragung mit einem Spalt zwischen den beiden Kontaktflächen der Magnetkerne. Auch die JP 2004 022779 beschäftigt sich mit der induktiven Energieübertragung, wobei eine Zwischenschicht den direkten und spaltfreien Kontakt der beiden Magnetkerne verhindert. Die US 4,929,005 beschreibt die induktive Energieübertragung auf dem technischen Gebiet von Türen und Fenstern. Zur Vermeidung von Luftspalten werden die Magnetkerne durch Federn aneinander gedrückt.

Aus der JP 2003 142327 ist ebenfalls eine grundsätzlich induktive Übertragung von Energie bekannt , in diesem Fall mit drehbarer Lagerung eines der Magnetkerne zum Ausgleich von Verkippungen der Magnetkerne zueinander.

Eine derartige externe Steckerverbindung bringt erhebliche Handlingsnachteile mit sich. Der Bediener des Bestückautomaten muss beim Umrüsten der Zuführeinrichtungen bis zu drei Gurtrollen und die Zuführeinrichtung tragen und gleichzeitig die Zuführeinrichtung durch Ziehen des Steckers von der Stromversorgung trennen. Normalerweise ist dafür ein zweiter Bediener erforderlich. Da das Umrüsten des Bestückautomaten außerdem schnell vonstatten gehen muss, wird das Ziehen des Steckers leicht vergessen, was zum Ausreißen des Steckers und zur Beschädigung der Zuführeinrichtung führt.

Es ist deshalb die Aufgabe der vorliegenden Erfindung, eine Vorrichtung zur Stromversorgung einer Zuführeinrichtung in einem Bestückautomaten, eine Zuführeinrichtung sowie einen Bestückautomaten zu liefern, die das Handling der Zuführeinrichtungen vereinfachen. Diese Aufgabe wird durch eine Vorrichtung gemäß dem unabhängigen Anspruch 1, eine Zuführeinrichtung gemäß Anspruch 9 und einen Bestückautomaten gemäß Anspruch 13 gelöst.

Erfindungsgemäß erfolgt die Energieüberragung zwischen einem Bestückautomaten und einer zugehörigen Zuführeinrichtung für Bauelemente induktiv. Die erfindungsgemäße Vorrichtung gemäß Anspruch 1 umfasst daher einen mit einer Primärspule umwickelten ersten Magnetkern, der dem Bestückautomaten zugeordnet ist, und einen mit einer Sekundärspule umwickelten zweiten Magnetkern, der der Zuführeinrichtung zugeordnet und mit dem ersten Magnetkern gekoppelt ist. Zur Gewährleistung einer möglichst starken Bündelung des magnetischen Felds bzw. einer guten Energieübertragung sind die Magnetkerne aus einem Material mit hoher magnetischer Permeabilität (d.h. hoher Durchlässigkeit für magnetische Felder), beispielsweise aus Ferrit, gefertigt. Um einen sicheren Kontakt der beiden Magnetkerne zu gewährleisten, ist zumindest entweder der erste Magnetkern gegenüber den Bestückautomaten oder der zweite Magnetkern gegenüber der Zuführeinrichtung durch zwei Schraubenfedern federnd gelagert, so dass er gegen den jeweils anderen Magnetkern gedrückt wird und die einander zugewandten Kontaktflächen der Magnetkerne ohne Spalt sicher aneinander liegen. Durch die induktive Energieübertragung kann auf einen Stecker verzichtet werden. Dadurch ergeben sich für den Bediener erhebliche Handlingsvorteile beim Umrüsten der Zuführeinrichtung und ein Ausreißen eines Steckers ist nicht mehr möglich.

Zusätzlich ist der federnd gelagerte Magnetkern drehbar gelagert ist. Dadurch wird gewährleistet, dass die einander zugewandten Kontaktflächen des ersten und zweiten Magnetkerns im angedrückten Zustand immer parallel aneinander anliegen. Auf Seiten des Bestückautomaten kann es durch Wärmeverzug zu Verformungen in den Lagern des Magnetkerns kommen, so dass zwischen den Magnetkernen der Bestückautomaten und der Zuführeinrichtung ein Spalt entsteht. Dadurch, dass der federnd gelagerte Magnetkern, sei es auf Seiten des Bestückautomaten oder auf Seiten der Zuführeinrichtung, zusätzlich drehbar gelagert ist, können solche Änderungen in den Lagern der Magnetkerne ausgeglichen werden.

Eine Ausgestaltung der Vorrichtung nach Anspruch 2 zeichnet sich dadurch aus, dass der zweite Magnetkern so schmal ausgeführt ist, dass er die Breite der Zuführeinrichtung nicht überschreitet, und dass er in Bereichen, wo er mit der Sekundärspule umwickelt ist, zusammen mit der Sekundärspule die Breite der Zuführeinrichtung nicht überschreitet. Da Zuführeinrichtungen besonders schmal ausgeführt werden, um auf dem vorgegebenen Raum möglichst viele davon am Bestückautomaten vorsehen zu können, ist der zweite Magnetkern so schmal ausgebildet, dass er selbst zusammen mit der Sekundärspule nicht über die Zuführeinrichtung hinausragt. Dadurch kann ein niedriges Rastermaß der Zuführeinrichtung am Bestückautomaten eingehalten werden.

Gemäß einer weiteren vorteilhaften Ausgestaltung nach Anspruch 3 ist der erste Magnetkern so schmal ausgeführt, dass er die Breite der Zuführeinrichtung nicht überschreitet, und dass er in Bereichen, wo er mit der Primärspule umwickelt ist, zusammen mit der Primärspule die Breite der Zuführeinrichtung nicht überschreitet. Dadurch wird gewährleistet, dass auch auf Seiten des Bestückautomaten die Magnetkerne so schmal ausgeführt sind, dass sie mit demselben Rastermaß wie die Zuführeinrichtungen angebracht werden können. Somit stehen sich die Magnetkerne auf beiden Seiten immer gegenüber.

In einer weiteren vorteilhaften Ausgestaltung gemäß Anspruch 4 weist der zweite Magnetkern die Gestalt des lateinischen Buchstaben "E" auf, wobei nur der mittlere Schenkel mit der Sekundärspule umwickelt ist. Diese Form des Magnetkerns erlaubt eine sehr effiziente Energieübertragung.

Gemäß Anspruch 5 weist auch der erste Magnetkern eine E-förmige Gestalt auf, wobei auch hier nur der mittlere Schenkel mit der Primärspule umwickelt ist. Im angedrückten Zustand berühren sich der erste und der zweite Magnetkern jeweils an ihren freien Stirnflächen der drei Schenkel. Dadurch, dass sowohl der Magnetkern auf Seiten des Bestückautomaten als auch der Magnetkern auf Seiten der Zuführeinrichtung eine E-Form aufweist, kann die Effizienz der induktiven Energieübertragung weiter gesteigert werden.

Darüber hinaus kann, gemäß einer weiteren vorteilhaften Ausgestaltung nach Anspruch 6, das die drei Schenkel verbindende Rückenteil des E-förmigen zweiten Magnetkerns zumindest im Bereich der Verlängerung des mittleren Schenkels so schmal ausgebildet sein, dass es zumindest auf einer Seite des zweiten Magnetkerns bündig mit dem mittleren Schenkel abschließt, um dort Anschlussleitungen der Sekundärspule führen zu können. Wie oben schon erwähnt, soll die Gesamtheit des zweiten Magnetkerns mit der Sekundärspule die Breite der Zuführeinrichtung nicht überschreiten. Um zu verhindern, dass die Zuführleitungen der Sekundärspule über die Zuführeinrichtung seitlich hinausragen, ist das die drei Schenkel verbindende Rückenteil des E-förmigen Magnetkerns zumindest im Bereich der Verlängerung des mittleren Schenkels so schmal ausgebildet, dass dort die Anschlussleitungen der Sekundärspule geführt werden können.

Entsprechend ist gemäß einer vorteilhaften Ausgestaltung der Vorrichtung nach Anspruch 7 auch das die drei Schenkel verbindende Rückenteil des ersten E-förmigen Magnetkerns zumindest im Bereich der Verlängerung des mittleren Schenkels so schmal ausgebildet, dass dieses Rückenteil zumindest auf einer Seite des ersten Magnetkerns bündig mit dem mittleren Schenkel abschließt, um dort Anschlussleitungen der Primärspule zu führen. Dadurch wird gewährleistet, dass die Anschlussleitungen der Primärspule seitlich nicht über den ersten Magnetkern hinausragen und der erste Magnetkern zusammen mit der darauf aufgewickelten Primärspule und den dazugehörigen Anschlüssen nicht über die Breite der Zuführeinrichtung hinausgeht. Somit kann auf Seiten des Bestückautomaten ein möglichst enges Rastermaß erster Magnetkerne erreicht werden, wodurch eine möglichst große Anzahl von Zuführeinrichtungen an den Bestückautomaten angebracht werden kann.

In der vorteilhaften Ausgestaltung nach Anspruch 8 sind die Primärspule mit einer dem Bestückautomaten zugeordneten Spannungsquelle und die Sekundärspule mit einem der Zuführeinrichtung zugeordneten Verbraucher elektrisch verbunden. Zu den Verbrauchern zählen Antriebsmotoren und Steuerelektronik. Dadurch ergibt sich, dass die elektrische Energieversorgung zentral auf Seiten des Bestückautomaten vorgesehen und die elektrische Energie mittels induktiver Energieübertragung auf die Zuführeinrichtung übertragen wird.

Die Erfindung gemäß Anspruch 9 betrifft eine Zuführeinrichtung für Bauelemente für einen Bestückautomaten, die ein Zuführeinrichtungsgehäuse und einen zweiten Magnetkern aufweist, der mit einer Sekundärspule, die ihrerseits mit einem der Zuführeinrichtungen zugeordneten Verbraucher elektrisch verbunden ist, umwickelt ist, wobei der zweite Magnetkern so angeordnet ist, dass er mit einem dem Bestückautomaten zugeordneten ersten Magnetkern, der seinerseits mit einer Primärspule umwickelt ist, koppelbar ist, und der zweite Magnetkern gegenüber der Zuführeinrichtung durch zwei Schraubenfedern federnd gelagert ist, so dass der zweite Magnetkern im gekoppelten Zustand gegen den ersten Magnetkern gedrückt wird. Durch das Andrücken des zweiten Magnetkerns gegen den ersten Magnetkern mittels dieser federnden Lagerung, wird sichergestellt, dass beide Magnetkerne fest und ohne Spalt gegeneinander angedrückt werden. Dies gewährleistet eine hohe Effizienz der Energieübertragung im gekoppelten Zustand.

Zusätzlich ist der zweite Magnetkern drehbar gelagert, so dass die einander zugewandten Kontaktflächen der ersten und zweiten Magnetkerne im angedrückten Zustand parallel aneinander liegen. Somit können eventuelle Verformungen in den Lagern der Magnetkerne auf Seiten des Bestückautomaten, beispielsweise durch Wärmeverzug, durch die drehbare Lagerung des zweiten Magnetkerns ausgeglichen werden, so dass beide Magnetkerne im angedrückten bzw. gekoppelten Zustand parallel zueinander anliegen und sich kein Spalt zwischen den beiden Magnetkernen bildet. Somit kann die hohe Effizienz der Energieübertragung auch bei leicht veränderter Position der Magnetkerne auf Seiten des Bestückautomaten aufrechterhalten werden.

In der vorteilhaften Ausgestaltung der Zuführeinrichtung gemäß Anspruch 10 ist der zweite Magnetkern so schmal ausgeführt ist, dass er das Zuführeinrichtungsgehäuse nicht überschreitet, und dass er in Bereichen, wo er mit der Sekundärspule umwickelt ist, zusammen mit der Sekundärspule die Breite des Zuführeinrichtungsgehäuses nicht überschreitet. Der zweite Magnetkern übersteigt selbst zusammen mit der darauf aufgewickelten Spule nicht die Breite des Zuführeinrichtungsgehäuses, welches die Mechanik und Steuerelektronik der Zuführeinrichtung in sich aufnimmt. Dadurch wird ein enges Rastermaß der Zuführeinrichtungen am Bestückautomaten erreicht.

In einer weiteren vorteilhaften Ausgestaltung der Erfindung nach Anspruch 11 weist der zweite Magnetkern die Gestalt des lateinischen Buchstaben "E" auf, wobei dessen mittlerer Schenkel von der Sekundärspule umwickelt ist. Grund für diese E-förmige Gestalt des Magnetkerns ist eine höhere Effizienz der Energieübertragung.

Darüber hinaus kann in einer weiteren vorteilhaften Ausgestaltung der Zuführeinrichtung gemäß Anspruch 12 das die drei Schenkel verbindende Rückenteil des E-förmigen zweiten Magnetkerns zumindest im Bereich der Verlängerung des mittleren Schenkels so schmal ausgebildet sein, dass es zumindest auf einer Seite des zweiten Magnetkerns bündig mit dem mittleren Schenkel abschließt, so dass dort die Anschlussleitungen der Sekundärspule führbar sind. Durch diese Ausgestaltung des E-Kerns können die Anschlussleitungen bündig mit dem zweiten Magnetkern geführt werden und es wird verhindert, dass die Anschlussleitungen der Sekundärspule über das Zuführeinrichtungsgehäuse hinausragen.

Der in Anspruch 13 beanspruchte Bestückautomat weist einen ersten Magnetkern auf, der mit einer Primärspule, die ihrerseits mit einer dem Bestückautomaten zugeordneten Spannungsquelle elektrisch verbunden ist, umwickelt ist, wobei der erste Magnetkern so angeordnet ist, dass er mit einem einer Zuführeinrichtung für Bauelemente zugeordneten zweiten Magnetkern, der mit einer Sekundärspule umwickelt ist, koppelbar ist, und der erste Magnetkern gegenüber dem Bestückautomaten durch zwei Schraubenfedern derart federnd gelagert ist, dass der erste Magnetkern im gekoppelten Zustand gegen den zweiten Magnetkern gedrückt wird. Durch die federnde Lagerung wird erreicht, dass der erste Magnetkern auf Seiten des Bestückautomaten im gekoppelten Zustand fest gegen die entsprechenden Kontaktflächen des zweiten Magnetkerns gedrückt wird, was die Effizienz der induktiven Energieübertragung steigert.

Zusätzlich ist der erste Magnetkern drehbar gelagert, so dass die einander zugewandten Kontaktflächen des ersten und des zweiten Magnetkerns im angedrückten Zustand parallel aneinander anliegen. Ändert sich die Lage der Magnetkerne sowohl auf Seiten des Bestückautomaten als auch auf Seiten der Zuführeinrichtung durch Wärmeverzug, so kann dies durch die drehbare Lagerung des gefederten ersten Magnetkerns ausgeglichen werden, so dass die Magnetkerne auch in dieser Situation immer parallel aneinander anlegen. Dadurch wird eine Spaltbildung zwischen den Magnetkernen verhindert und die hohe Effizienz der Energieübertragung wird aufrechterhalten.

In der vorteilhaften Ausgestaltung des Bestückautomaten nach Anspruch 14 ist der erste Magnetkern so schmal ausgeführt, dass er die Breite der Zuführeinrichtung nicht überschreitet, und dass er in Bereichen, wo er mit der Primärspule umwickelt ist, zusammen mit der Primärspule die Breite der Zuführeinrichtung nicht überschreitet. Dadurch ist es möglich, an dem Bestückautomaten möglichst viele Zuführeinrichtungen vorzusehen, und dass sich die Magnetkerne auf Seiten der Zuführeinrichtung und des Bestückautomaten immer genau gegenüberstehen.

Der Bestückautomat kann gemäß Anspruch 15 vorteilhafterweise so ausgestaltet sein, dass der erste Magnetkern die Gestalt des lateinischen Buchstaben "E" aufweist, dessen mittlerer Schenkel von der Primärspule umwickelt ist. Wie oben schon erwähnt wurde, kann durch die E-förmige Gestalt des Magnetkerns eine hohe Effizienz der induktiven Energieübertragung erreicht werden.

Vorteilhafterweise kann der Bestückautomat gemäß Anspruch 16 dadurch gekennzeichnet sein, dass das die drei Schenkel verbindende Rückenteil des ersten Magnetkerns zumindest im Bereich der Verlängerung des mittleren Schenkels so schmal ausgebildet ist, dass es zumindest auf einer Seite des ersten Magnetkerns bündig mit dem mittleren Schenkel abschließt, um dort Anschlussleitungen der Primärspule zu führen. Durch diese Ausbildung des E-förmigen Magnetkerns, können auf Seiten des Bestückautomaten die Magnetkerne sehr eng nebeneinander platziert werden. Dadurch ist es auch möglich, eine große Anzahl an Zuführeinrichtungen an den Bestückautomaten zu koppeln.

Im Folgenden wird ein vorteilhaftes Ausführungsbeispiel der vorliegenden Erfindung mit Bezug auf die beigefügten Zeichnungen genauer beschrieben. Dabei zeigt:
Figur 1 eine Seitenansicht eines vorteilhaften Ausführungsbeispiels der erfindungsgemäßen Vorrichtung;
Figur 2 eine perspektivische Ansicht einer vorteilhaften Ausgestaltung einer Zuführeinrichtung der vorliegenden Erfindung;
Figur 3 eine Querschnittsansicht eines vorteilhaften Magnetkerns mit zugehörigem Gehäuse der vorliegenden Erfindung;
Figur 4 eine Vorderansicht eines vorteilhaften Magnetkerns inklusive Gehäuse der erfindungsgemäßen Vorrichtung;
Figur 5 eine Seitenansicht eines vorteilhaftes Ausführungsbeispiel eines Magnetkerns der erfindungsgemäßen Vorrichtung;
Figur 6 eine Teil-Vorderansicht eines vorteilhaften Ausführungsbeispiels eines Magnetkern der erfindungsgemäßen Vorrichtung;
Figur 7 eine weitere Seitenansicht eines vorteilhaften Ausführungsbeispiels des Magnetkerns der erfindungsgemäßen Vorrichtung.

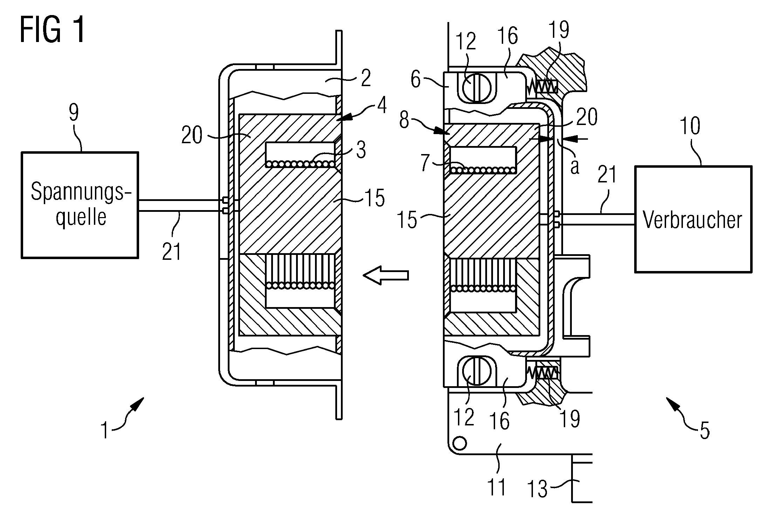

In Fig. 1 ist eine vorteilhafte Ausgestaltung der erfindungsgemäßen Vorrichtung zur induktiven Energieübertragung dargestellt. Auf Seiten eines Bestückautomaten (1) (in Fig. 1 links dargestellt) ist in einem ersten Gehäuse (2) ein mit einer Primärspule (3) umwickelter erster Magnetkern (4) vorgesehen. Das erste Gehäuse (2) ist zusammen mit dem ersten Magnetkern (4) fest mit dem Bestückautomaten (1) verbunden. An einer dem Bestückautomaten (1) zugewandten Stirnseite einer Zuführeinrichtung (5) (in Figur 1 rechts dargestellt) ist in einem zweiten Gehäuse (6) ein mit einer Sekundärspule (7) umwickelter zweiter Magnetkern (8) vorgesehen. Beide Magnetkerne (4), (8) sind aus einem Material mit hoher magnetischer Permeabilität (d.h. hoher Durchlässigkeit für magnetische Felder), beispielsweise aus Ferrit, gefertigt, um eine möglichst starke Bündelung des Magnetfelds und damit eine gute Energieübertragung zu gewährleisten. Wie der Fig. 1 zu entnehmen ist, sind der erste Magnetkern (4) mit der Primärspule (3) auf Seiten des Bestückautomaten (1) und der zweite Magnetkern (8) mit der Sekundärspule (7) auf Seiten der Zuführeinrichtung (5) identisch ausgeführt. Die Primärspule (3) des ersten Magnetkerns (4) ist mit einer dem Bestückautomaten (1) zugeordneten Spannungsquelle (9) elektrisch verbunden, wogegen die Sekundärspule (7) des zweiten Magnetkerns (8) mit einem oder mehreren Verbrauchern (10) auf Seiten der Zuführeinrichtung (5) elektrisch verbunden ist. Durch Aneinanderbringen der beiden Magnetkerne kommt es zu einer induktiven Energieübertragung von der Spannungsquelle (9) zu den Verbrauchern (10).

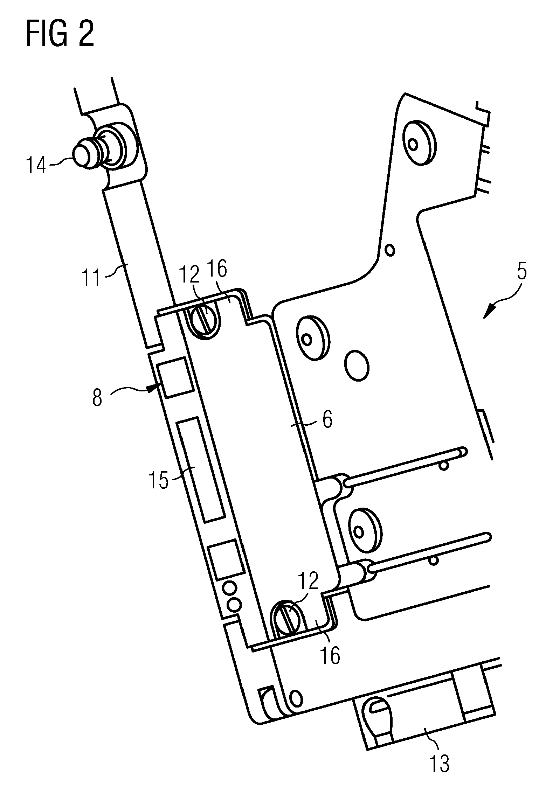

In Figur 2 ist ein vorteilhaftes Ausführungsbeispiel einer Zuführeinrichtung (5) teilweise perspektivisch dargestellt. Die Zuführeinrichtung (5) weist ein Zuführeinrichtungsgehäuse (11) auf, in dem die gesamte Elektronik und Mechanik der Zuführeinrichtung (5), wie beispielsweise elektrische Vorschubmotoren oder eine Steuereinheit, untergebracht sind. Das zweite Gehäuse (6) des zweiten Magnetkerns (8) ist mittels zweier Schrauben (12) an der Vorderseite des Gehäuses der Zuführeinrichtung (5) angebracht. Kontaktflächen des sich in dem zweiten Gehäuse (6) befindlichen zweiten Magnetkerns (8) sind auf der dem Bestückautomaten (1) zugewandten Seite des zweiten Gehäuses (6) offen gelegt und schließen bündig mit dem zweiten Gehäuse (6) ab. An der Unterseite des Zuführeinrichtungsgehäuses (11) sind Führungselemente (13) vorgesehen. Zum Anbringen der Zuführeinrichtung (5) am Bestückautomaten (1), wird die Zuführeinrichtung (5) mit den Führungselementen (13) auf entsprechende Führungsschienen (nicht dargestellt) am Bestückautomaten (1) aufgesetzt und entlang der Führungsschienen in einer Verschieberichtung (in Fig. 1 durch einen Pfeil gekennzeichnet) bis zum Anschlag an den Bestückautomaten (1) gefahren (gekoppelter Zustand). An der Vorderseite der Zuführeinrichtung (5) ist ein Justierbolzen (16) vorgesehen, der beim Anbringen der Zuführeinrichtung (5) in eine entsprechende Aufnahmeöffnung auf Seiten des Bestückautomaten (1) einrastet. Der Justierbolzen (16) dient der Stabilisierung der Zuführeinrichtung (5) und fixiert diese in ihrer vorgesehenen Lage.

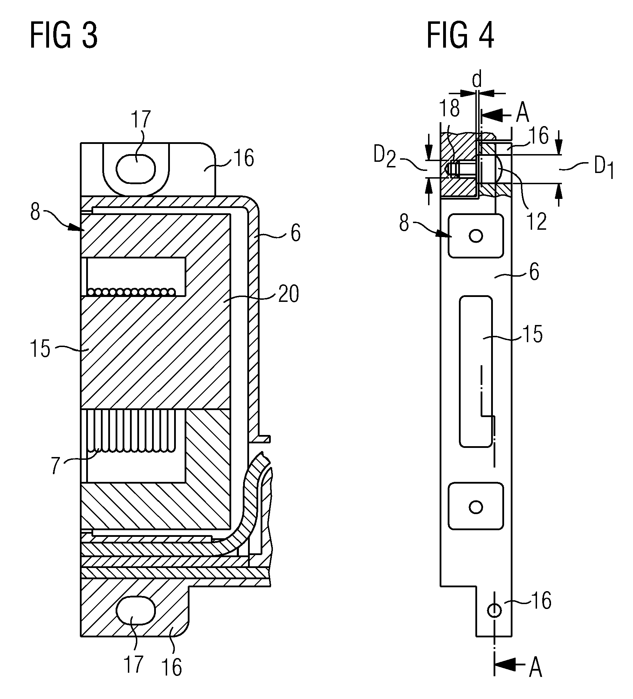

Anhand der Figuren 3 und 4 wird ein vorteilhafter Aufbau des in Fig. 1 gezeigten zweiten Gehäuses (6) mit dem darin untergebrachten zweiten Magnetkern (8) näher erläutert. Figur 3 stellt dabei eine Querschnittansicht entlang der Linie A-A in Fig. 4 dar. Der dargestellte zweite Magnetkern (8) weist die Form des lateinischen Buchstabens "E" auf, dessen mittlerer Schenkel (15) mit der Sekundärspule (7) umwickelt ist. Das zweite Gehäuse (6) des zweiten Magnetkerns (8) weist an der Ober- und Unterseite jeweils eine flanschartige Erweiterung (16) auf, die ein in Verschieberichtung der Zuführeinrichtung (5) gerichtetes Langloch (17) aufweist. Aus der in Figur 4 dargestellten Vorderansicht des zweiten Gehäuses (6) des zweiten Magnetkerns (8) wird deutlich, wie das zweite Gehäuse (6) mittels Schrauben (12) an dem Zuführeinrichtungsgehäuse (11) befestigt wird. Am Zuführeinrichtungsgehäuse (11) sind Gewindebohrungen (18) so vorgesehen, dass das zweite Gehäuse (6) des zweiten Magnetkerns (8) mittels der durch die Langlöcher (17) geführten Schraube (12) am Zuführeinrichtungsgehäuse (11) befestigt werden kann. Der vertikale Durchmesser (D1) der Langlöcher (17) ist dabei größer ausgeführt als der Gewindedurchmesser (D2) der Gewindebohrungen (18). Die zur Befestigung des zweiten Gehäuses (6) verwendeten Schrauben (12) weisen in einem vorderen Abschnitt ein zur Gewindebohrung (18) passendes Gewinde auf, wobei sich der Durchmesser des Schraubenschafts in der Nähe des Schraubenkopfes stufenartig erweitert, so dass sich die Schrauben (12) nur bis zu einem bestimmten Grad in die Bohrung (18) einschrauben lassen. Der Schraubenteil mit erweitertem Durchmesser ist z. B. um einige Zehntel Millimeter länger ausgeführt als die Breite der flanschartigen Erweiterung (16) des zweiten Gehäuses (6) des zweiten Magnetkerns (8). Dadurch wird verhindert, dass das zweite Gehäuse (6) des zweiten Magnetkerns (8) vollkommen fest an dem Gehäuse (9) der Zuführeinrichtung (5) angeschraubt wird. Mit anderen Worten, existiert zwischen dem Gehäuse (9) der Zuführeinrichtung (5) und dem zweiten Gehäuse (6) des zweiten Magnetkerns (8) im angeschraubten Zustand ein gewisses Spiel (d). Das zweite Gehäuse (6) ist somit horizontal in der Verschieberichtung der Zuführeinrichtung (5) beweglich gelagert, wobei die Langlöcher (17) und die erweiterten Teile der Schraubenschäfte als Führungen dienen.

Aus Figur 4 geht ferner hervor, dass das zweite Gehäuse (6) zusammen mit dem darin enthaltenen zweiten Magnetkern (8) inklusive der Sekundärspule (7) die Breite des Zuführeinrichtungsgehäuses (11) nicht überschreitet. Durch die sehr schlanke Ausbildung des zweiten Magnetkerns (8) und seines zweiten Gehäuses (6) kann eine hohe Anzahl an Zuführeinrichtungen (5) in einem engen Rastermaß entlang dem Bestückautomaten (1) vorgesehen werden.

Wie in Figur 1 erkennbar ist, ist das zweite Gehäuse (6) des zweiten Magnetkerns (8) im montierten Zustand an seiner Rückseite über zwei Schraubenfedern (19) gegenüber dem Zuführeinrichtungsgehäuse (11) federnd gelagert. Die Schraubenfedern (19) werden vor der Montage des zweiten Gehäuses (6) des zweiten Magnetkerns (8) in entsprechende Bohrungen auf Seiten des Zuführeinrichtungsgehäuses (11) eingesetzt. Durch die Federkraft wird das beweglich gelagerte zweite Gehäuse (6) des zweiten Magnetkerns (8) im ungekoppelten Zustand (d.h. in einem Zustand, in dem die Zuführeinrichtung (5) noch nicht vollständig am Bestückautomaten (1) angebracht ist) in Verschieberichtung nach vorne gedrückt, so dass es an der Vorderseite der Zuführeinrichtung (5) etwas vorsteht. An Stelle der Schraubenfedern (19) können auch elastomerische Elemente, wie etwa Gummipfropfen vorgesehen werden. Wird die Zuführeinrichtung (5) nun entlang der Schienen des Bestückautomaten (1) bis zum Anschlag an den Bestückautomaten (1) geschoben, so wird das zweite Gehäuse (6) an das erste Gehäuse (2) des ersten Magnetkerns (4) gedrückt. Dadurch werden die an den Vorderseiten der Gehäuse der beiden Magnetkerne freiliegenden Kontaktflächen der Magnetkerne in Kontakt gebracht (gekoppelter Zustand). Da, wie oben erwähnt, das zweite Gehäuse (6) des zweiten Magnetkerns (8) im ungekoppelten Zustand geringfügig über die Vorderseite der Zuführeinrichtung (5) hinausragt, wird das zweite Gehäuse (6) beim Ankoppeln entgegen der Verschieberichtung der Zuführeinrichtung (5) bewegt, wodurch die beiden Schraubenfedern (19) zumindest teilweise zusammengedrückt werden. Die dadurch entstehende Andrückkraft drückt die Kontaktflächen des zweiten Magnetkerns (8) gegen die Kontaktflächen des ersten Magnetkerns (4). Auf diese Weise wird sichergestellt, dass zwischen den Kontaktflächen der beiden Magnetkerne kein Spalt entsteht, wodurch eine hohe Effizienz der induktiven Energieübertragung erreicht wird.

Weiterhin wird aus Figur 1 deutlich, dass zwischen der Oberseite, der Unterseite und der Rückseite des zweiten Gehäuse (6) und dem Gehäuse (9) der Zuführeinrichtung (5) ein gewisser Abstand (a) (typischerweise ein Millimeter) existiert. Dadurch ist das zweite Gehäuse (6) des zweiten Magnetkerns (8) gegenüber dem Zuführeinrichtungsgehäuse (11) nicht nur in der Verschieberichtung des Zuführeinrichtungsgehäuses (11) verschiebbar, sondern auch um eine zu den Schraubenschäften parallele Drehachse drehbar bzw. kippbar gelagert. Sollte sich also die relative Winkellage des ersten Gehäuses (2) des ersten Magnetkerns (4) auf Seiten des Bestückautomaten (1) zum Beispiel durch Wärmeverzug ändern, so kann sich das zweite Gehäuse (6) des zweiten Magnetkerns (8) auf Seiten der Zuführeinrichtung (5) im gekoppeltem bzw. angedrücktem Zustand durch leichtes Drehen bzw. Kippen an die geänderte Lage des ersten Gehäuses (2) des ersten Magnetkerns (4) anpassen. Somit wird gewährleistet, dass auch bei einer leicht veränderten Winkellage des ersten Gehäuses (2) die Kontaktflächen der ersten und zweiten Magnetkerne im angedrückten Zustand immer vollständig aneinander anliegen. Somit wird verhindert, dass zwischen den Kontaktflächen ein Luftspalt auftritt, wodurch eine höhere Effizienz der Energieübertragung erreicht wird.

Wie anfangs schon erwähnt wurde, sind in diesem Ausführungsbeispiel der erfindungsgemäßen Vorrichtung, der mit der Primärspule (3) umwickelte erste Magnetkern (4) und der mit der Sekundärspule (7) umwickelte zweite Magnetkern (8) identisch ausgebildet. Das erste Gehäuse (2) des ersten Magnetkerns (4) unterscheidet sich vom zweiten Gehäuse (6) des zweiten Magnetkerns (8) nur dadurch, dass es über keine Langlöcher (17) verfügt und dass es fest und ungefedert am Bestückautomaten (1) angebracht ist. Gleichzeitig ist das erste Gehäuse (2) zusammen mit dem darin untergebrachten ersten Magnetkern (4)und der Primärspule (3) so schmal ausgeführt, dass es die Breite des Zuführeinrichtungsgehäuses (11) nicht überschreitet. Dies gewährleistet, dass wenn eine Vielzahl von Zuführeinrichtungen in einem engen Rastermaß an der Bestückeinrichtung angebracht wird, jedem der zweiten Magnetkerne (8) auf Seiten der Zuführeinrichtung (5) ein entsprechender erster Magnetkern (4) auf Seiten des Bestückautomaten (1) gegenüber steht.

Auch wenn in diesem Ausführungsbeispiel nur der zweite Magnetkern (8) auf Seiten der Zuführeinrichtung (5) drehbar und federnd gegenüber dem Zuführeinrichtungsgehäuse (11) gelagert ist und der erste Magnetkern (4) auf Seiten des Bestückautomaten (1) fest und unbeweglich befestigt ist, so sind auch Konstruktionen denkbar und vorteilhaft, bei der entweder das erste Gehäuse (2) des ersten Magnetkerns (4) federnd und drehbar gegenüber dem Bestückautomaten (1) gelagert ist und das zweite Gehäuse (6) des zweiten Magnetkerns (8) fest an der Zuführeinrichtung (5) fixiert ist, oder aber eine Konstruktion, bei der die Gehäuse sowohl des ersten als auch des zweiten Magnetkerns federnd und drehbar gelagert sind.

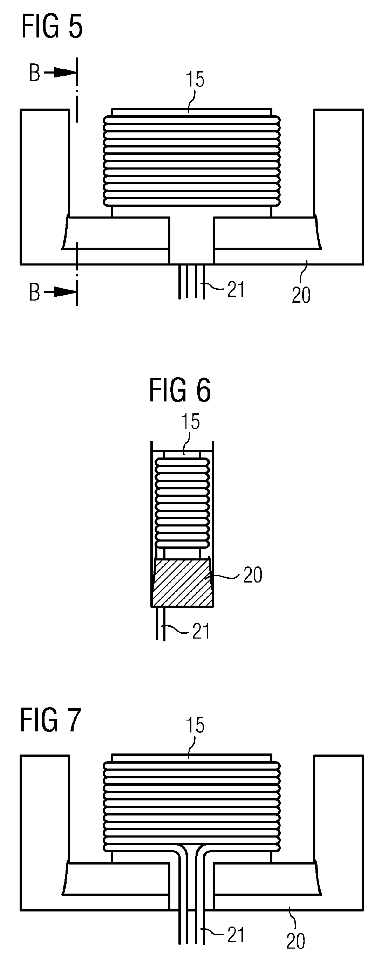

Eine vorteilhafte Ausgestaltung eines ersten oder zweiten Magnetkerns, wie er bei der vorteilhaften Ausgestaltungen der erfindungsgemäßen Vorrichtung eingesetzt wird, ist in den Figuren 5 bis 7 dargestellt und wird im Folgenden näher beschrieben.

Figur 5 zeigt eine Seitenansicht einer vorteilhaften Ausführungsform eines Magnetkerns. Der Magnetkern weist die Form des lateinischen Buchstaben "E" auf, wobei drei zueinander parallele Schenkel an jeweils einem ihrer Enden über ein Rückenteil (20) miteinander verbunden werden. Der mittlere der drei Schenkel ist mit einer Spule (welche eine Primär- oder eine Sekundärspule sein kann) umwickelt. Die Spule weist elektrische Anschlussleitungen (21) auf, mit der sie entweder mit einer Spannungsquelle (9) oder mit einem Verbraucher (10) elektrisch verbunden werden kann. Je nach dem, ob die Spule mit einer Spannungsquelle (9) oder mit einem Verbraucher (10) elektrisch verbunden ist, spricht man von Primär- oder Sekundärspule.

Figur 6 stellt eine Querschnittsansicht des Magnetkerns entlang der Querschnittslinie B-B in Figur 5 dar. Der mit der Spule umwickelte mittlere Schenkel (15) des E-förmigen Magnetkerns ist so schmal ausgebildet, dass er zusammen mit der darauf aufgewickelten Spule die Breite des restlichen Magnetkerns nicht überschreitet.

Figur 7 zeigt eine andere Seitenansicht des Magnetkerns. daraus geht hervor, dass das die drei Schenkel des Magnetkerns verbindende Rückenteil (20) im Bereich des mittleren Schenkels (15) so schmal ausgeführt, dass es an dieser Stelle bündig mit dem mittleren Schenkel (15) abschließt. In dieser Vertiefung des Rückenteils, können die Anschlussleitungen (21) der Spule versenkt geführt werden, so dass die Anschlussleitungen (21) seitlich nicht über den Magnetkern hinausragen. Dies wird auch noch in der Querschnittsansicht der Figur 6 deutlich, bei der zu sehen ist, dass die Anschlussleitungen (21) der Spule soweit in der Vertiefung des Rückenteils versenkt geführt sind, so dass diese nicht über die Breite des E-Kerns hinausragen. Dadurch wird einerseits gewährleistet, dass die Anschlussleitungen (21) nicht eingeklemmt und beschädigt werden, andererseits kann der Magnetkern zusammen mit der Spule sehr schmal und kompakt ausgeführt werden.

Allgemein ist anzumerken, dass die Magnetkerne erfindungsgemäß so gestaltet sind, dass sie zusammen mit den darauf aufgewickelten Spulen und dem eventuellen Gehäuse die Breite der Zuführeinrichtung (5) bzw. des Zuführeinrichtungsgehäuse (11) nicht überschreiten. Somit kann ein sehr enges Rastermaß der Zuführeinrichtung (5) an dem Bestückautomaten (1) gewährleistet werden.

Im oben beschriebenen Ausführungsbeispiel ist der mit der Primärspule (3) umwickelte erste Magnetkern (4) unmittelbar am Bestückautomaten 1 vorgesehen. Es wird jedoch darauf hingewiesen, dass sich der Erfindungsgedanke auch auf Ausgestaltungen erstreckt, bei denen der mit der Primärspule (3) umwickelte erste Magnetkern (4) nicht unmittelbar am Bestückautomaten 1 angeordnet ist. Beispielsweise kann der erste Magnetkern (4) entsprechend an einer mobilen Trägereinrichtung für die Zuführeinrichtungen (5), beispielsweise einem Wagen, vorgesehen sein, welche zusammen mit den Zuführeinrichtungen (5) an den Bestückautomaten (1) herangefahren und mit diesem über eine einzige Kabelverbindung (Stromkabel), welche die Energieübertragung zwischen dem Bestückautomaten (1) und den Zuführeinrichtungen (5) gewährleistet, gekoppelt wird. Auch in diesem Fall entfällt die Notwendigkeit, die Zuführeinrichtungen jeweils über ein Kabel mit dem Bestückautomaten zu verbinden, weshalb sich gleiche Vorteile ergeben.

### Bezugszeichenliste:

- 1: Bestückautomat
- 2: Erstes Gehäuse des ersten Magnetkerns
- 3: Primärspule
- 4: Erster Magnetkern
- 5: Zuführeinrichtung
- 6: Zweites Gehäuse des zweiten Magnetkerns
- 7: Sekundärspule
- 8: Zweiter Magnetkern
- 9: Spannungsquelle
- 10: Verbraucher
- 11: Zuführeinrichtungsgehäuse
- 12: Schraube
- 13: Führungselement
- 14: Justierbolzen
- 15: Mittlerer Schenkel
- 16: Flanschartige Erweiterung
- 17: Langloch
- 18: Gewindebohrung
- 19: Schraubenfeder
- 20: Rückenteil
- 21: Anschlussleitung

## Patentansprüche

1. Vorrichtung zur induktiven Energieübertragung zwischen einem Bestückautomaten (1) und einer Zuführeinrichtung (5) für Bauelemente, mit
- einem mit einer Primärspule (3) umwickelten ersten Magnetkern (4), der dem Bestückautomaten (1) zugeordnet ist,
- einem mit einer Sekundärspule (7) umwickelten zweiten Magnetkern (8), der der Zuführeinrichtung (5) zugeordnet und mit dem ersten Magnetkern (4) gekoppelt ist, wobei zumindest entweder der erste Magnetkern (4) gegenüber dem Bestückautomaten (1) oder der zweite Magnetkern (8) gegenüber der Zuführeinrichtung (5) durch zwei Schraubenfedern (19) derartig federnd gelagert ist, sodass er gegen den jeweils anderen Magnetkern gedrückt wird und die einander zugewandten Kontaktflächen der Magnetkerne ohne Spalt sicher aneinander liegen, wobei der federnd gelagerte Magnetkern durch die zwei Schraubenfedern (19) zusätzlich drehbar gelagert ist, sodass einander zugewandte Kontaktflächen der ersten und zweiten Magnetkerne (4,8) im angedrückten Zustand parallel aneinander liegen.

2. Vorrichtung nach Anspruch 1, **dadurch gekennzeichnet, dass** der zweite Magnetkern (8) so schmal ausgeführt ist, dass er die Breite der Zuführeinrichtung (5) nicht überschreitet, und dass er in Bereichen, wo er mit der Sekundärspule (7) umwickelt ist, zusammen mit der Sekundärspule (7) die Breite der Zuführeinrichtung (5) nicht überschreitet.

3. Vorrichtung nach einem der Ansprüche 1 bis 2, **dadurch gekennzeichnet, dass** der erste Magnetkern (4) so schmal ausgeführt ist, dass er die Breite der Zuführeinrichtung (5) nicht überschreitet, und dass er in Bereichen, wo er mit der Primärspule (3) umwickelt ist, zusammen mit der Primärspule (3) die Breite der Zuführeinrichtung (5) nicht überschreitet.

4. Vorrichtung nach einem der Ansprüche 1 bis 3, **dadurch gekennzeichnet, dass** der zweite Magnetkern (8) eine E-förmige Gestalt aufweist, wobei nur der mittlere Schenkel (15) mit der Sekundärspule (7) umwickelt ist.

5. Vorrichtung nach Anspruch 4, **dadurch gekennzeichnet, dass** der erste Magnetkern (4) eine E-förmige Gestalt aufweist, wobei nur der mittlere Schenkel (15) mit der Primärspule (3) umwickelt ist, und sich der erste und der zweite Magnetkern (4,8) im angedrückten Zustand jeweils an den freien Stirnflächen der drei Schenkel berühren.

6. Vorrichtung nach Anspruch 4, **dadurch gekennzeichnet, dass** das die drei Schenkel verbindende Rückenteil (20) des zweiten Magnetkerns (8) zumindest im Bereich der Verlängerung des mittleren Schenkels (15) so schmal ausgebildet ist, dass es zumindest auf einer Seite des zweiten Magnetkerns (8) bündig mit dem mittleren Schenkel (15) abschließt, um dort Anschlussleitungen (21) der Sekundärspule (7) zu führen.

7. Vorrichtung nach Anspruch 5, **dadurch gekennzeichnet, dass** das die drei Schenkel verbindende Rückenteil (20) des ersten Magnetkerns (4) zumindest im Bereich der Verlängerung des mittleren Schenkels (15) so schmal ausgebildet ist, dass es zumindest auf einer Seite des ersten Magnetkerns (4) bündig mit dem mittleren Schenkel (15) abschließt, um dort Anschlussleitungen (21) der Primärspule (3) zu führen.

8. Vorrichtung nach einem der Ansprüche 1 bis 7, **dadurch gekennzeichnet, dass** die Primärspule (3) mit einer dem Bestückautomaten (1) zugeordneten Spannungsquelle (9) und die Sekundärspule (7) mit einem der Zuführeinrichtung (5) zugeordneten Verbraucher (10) elektrisch verbunden ist.

9. Zuführeinrichtung (5) für Bauelemente für einen Bestückautomaten (1), mit einem Zuführeinrichtungsgehäuse (11), einem zweiten Magnetkern (8), der mit einer Sekundärspule (7), die mit einem der Zuführeinrichtung (5) zugeordneten Verbraucher (10) elektrisch verbunden ist, umwickelt ist, wobei der zweite Magnetkern (8) so angeordnet ist, dass er mit einem dem Bestückautomaten (1) zugeordneten ersten Magnetkern (4), der mit einer Primärspule (3) umwickelt ist, koppelbar ist und der zweite Magnetkern (8) gegenüber der Zuführeinrichtung (5) durch zwei Schraubenfedern (19) gelagert ist, sodass der zweite Magnetkern (8) im gekoppelten Zustand gegen den ersten Magnetkern (4) gedrückt wird und die einander zugewandten Kontaktflächen der Magnetkerne ohne Spalt sicher aneinander liegen , wobei der zweite Magnetkern (8) durch die zwei Schraubenfedern (19) zusätzlich drehbar gelagert ist, sodass einander zugewandte Kontaktflächen der ersten und zweiten Magnetkerne (4,8) im angedrückten Zustand parallel aneinander liegen.

10. Zuführeinrichtung (5) nach Anspruch 9, **dadurch gekennzeichnet, dass** der zweite Magnetkern (8) so schmal ausgeführt ist, dass er die Breite des Zuführeinrichtungsgehäuses (11) nicht überschreitet, und dass er in Bereichen, wo er mit der Sekundärspule (7) umwickelt ist, zusammen mit der Sekundärspule (7) die Breite des Zuführeinrichtungsgehäuses (11) nicht überschreitet.

11. Zuführeinrichtung (5) nach Anspruch 10, **dadurch gekennzeichnet, dass** der zweite Magnetkern (8) eine E-förmige Gestalt aufweist, dessen mittlerer Schenkel (15) von der Sekundärspule (7) umwickelt ist.

12. Zuführeinrichtung (5) nach Anspruch 11, **dadurch gekennzeichnet, dass** das die drei Schenkel verbindende Rückenteil (20) des zweiten Magnetkerns (8) zumindest im Bereich der Verlängerung des mittleren Schenkels (15) so schmal ausgebildet ist, dass es zumindest auf einer Seite des zweiten Magnetkerns (8) bündig mit dem mittleren Schenkel (15) abschließt, um dort Anschlussleitungen (21) der Sekundärspule (7) zu führen.

13. Bestückautomat (1) zum Bestücken eines Substrats mit Bauelementen, mit einem ersten Magnetkern (4), der mit einer Primärspule (3), die mit einer dem Bestückautomaten (1) zugeordneten Spannungsquelle (9) elektrisch verbunden ist, umwickelt ist, wobei der erste Magnetkern (4) so angeordnet ist, dass er mit einem einer Zuführeinrichtung (5) für Bauelemente zugeordneten zweiten Magnetkern (8), der mit einer Sekundärspule (7) umwickelt ist, koppelbar ist, und der erste Magnetkern (4) gegenüber dem Bestückautomaten (1) durch zwei Schraubenfedern (19) federnd gelagert ist, sodass der erste Magnetkern (4) im gekoppelten Zustand gegen den zweiten Magnetkern (8) gedrückt wird und die einander zugewandten Kontaktflächen der Magnetkerne ohne Spalt sicher aneinander liegen, wobei der erste Magnetkern (4) durch die zwei Schraubenfedern (19) zusätzlich drehbar gelagert ist, so dass einander zugewandte Kontaktflächen der ersten und zweiten Magnetkerne (4,8) im angedrückten Zustand parallel aneinander liegen.

14. Bestückautomat (1) nach Anspruch 13, **dadurch gekennzeichnet, dass** der erste Magnetkern (4) so schmal ausgeführt ist, dass er die Breite der Zuführeinrichtung (5) nicht überschreitet, und dass er in Bereichen, wo er mit der Primärspule (3) umwickelt ist, zusammen mit der Primärspule (3) die Breite der Zuführeinrichtung (5) nicht überschreitet.

15. Bestückautomat (1) nach Anspruch 14, **dadurch gekennzeichnet, dass** der erste Magnetkern (4) eine E-förmige Gestalt aufweist, dessen mittlerer Schenkel (15) von der Primärspule (3) umwickelt ist.

16. Bestückautomat (1) nach Anspruch 15, **dadurch gekennzeichnet, dass** das die drei Schenkel verbindende Rückenteil (20) des ersten Magnetkerns (4) zumindest im Bereich der Verlängerung des mittleren Schenkels (15) so schmal ausgebildet ist, dass es zumindest auf einer Seite des ersten Magnetkerns (4) bündig mit dem mittleren Schenkel (15) abschließt, um dort Anschlussleitungen der Primärspule (3) zu führen.

## Claims

1. Device for inductive energy transmission between a placement unit (1) and a component feeding unit (5), having
- a first magnetic core (4) wound with a primary coil (3), which is assigned to the automatic placement unit (1),
- a second magnetic core (8) wound with a secondary coil (7), which is assigned to the feeding unit (5) and is coupled to the first magnetic core (4), wherein at least either the first magnetic core (4) is elastically mounted relative to the placement machine (1) or the second magnetic core (8) is elastically mounted relative to the feeding unit (5) by means of two helical springs (19), in such a way that it is pressed against the other magnetic core and the contact surfaces of the magnetic cores facing toward each other rest securely in contact with each other without a gap, wherein the elastically mounted magnetic core is additionally rotatably mounted by means of the two helical springs (19), so that contact surfaces of the first and second magnetic cores (4, 8) facing towards each other are parallel to each other in the pressed-on state.

2. Device according to claim 1,
**characterized in that**
the second magnetic core (8) is designed so narrow that it does not exceed the width of the feeding unit (5), and that in areas where it is wound with the secondary coil (7), together with the secondary coil (7), it does not exceed the width of the feeding unit (5).

3. Device according to any one of claims 1 to 2,
**characterized in that**
the first magnetic core (4) is designed so narrow that it does not exceed the width of the feeding unit (5) and that in areas where it is wound with the primary coil (3), together with the primary coil (3), it does not exceed the width of the feeding unit (5).

4. Device according to any one of claims 1 to 3,
**characterized in that**
the second magnetic core (8) has an E-shape, wherein only the middle arm (15) is wound with the secondary coil (7).

5. Device according to claim 4,
**characterized in that**
the first magnetic core (4) has an E-shape, wherein only the middle arm (15) is wound with the primary coil (3), and the first and the second magnetic core (4, 8) touch each other at each of the free end faces of the three arms in the pressed-on state.

6. Device according to claim 4,
**characterized in that**
the rear part (20) of the second magnetic core (8) connecting the three arms, at least in the area of the extension of the central arm (15), is designed so narrow that, on at least one side of the second magnetic core (8), it terminates flush with the central arm (15) in order to pass connecting cables (21) of the secondary coil (7) there.

7. Device according to claim 5,
**characterized in that**
the rear part (20) of the second magnetic core (4) connecting the three arms, at least in the area of the extension of the central arm (15), is designed so narrow that, on at least one side of the first magnetic core (4), it terminates flush with the central arm (15) in order to pass connecting cables (21) of the primary coil (3) there.

8. Device according to any one of claims 1 to 7,
**characterized in that**
the primary coil (3) is electrically connected to a voltage source (9) assigned to the placement unit (1) and the secondary spool (7) is electrically connected to a load (10) assigned to the feeding unit (5).

9. Feeding unit (5) for components for a placement unit (1), with a feeding unit housing (11), a second magnetic core (8), wound with a secondary coil (7), which is electrically connected to a load (10) assigned to the feeding unit (5), wherein the second magnetic core (8) is arranged such that it can be coupled to a first magnetic core (4), wound with a primary coil (3), which is assigned to the placement unit (1), and the second magnetic core (8) is mounted in relation to the feeding unit (5) by means of two helical springs (19) so that in the coupled state the second magnetic core (8) is pressed against the first magnetic core (4) and the contact surfaces of the magnetic cores facing toward each other rest securely in contact with each other without a gap, wherein the second magnetic core (8) is additionally rotatably mounted by means of the two helical springs (19), so that the contact surfaces of the first and second magnetic cores (4, 8) facing each other are parallel to each other in the pressed-on state.

10. Feeding unit (5) according to claim 9,
**characterized in that**
the second magnetic core (8) is designed so narrow that it does not exceed the width of the feeding unit housing (11), and that in areas where it is wound with the secondary coil (7), together with the secondary coil (7) it does not exceed the width of the feeding unit housing (11).

11. Feeding unit (5) according to claim 10,
**characterized in that**
the second magnetic core (8) has an E-shape, the central arm (15) of which is wound with the secondary coil (7).

12. Feeding unit (5) according to claim 11,
**characterized in that**
the rear part (20) of the second magnetic core (8) connecting the three arms, at least in the area of the extension of the central arm (15), is designed so narrow that, on at least one side of the second magnetic core (8), it terminates flush with the central arm (15) in order to pass connecting cables (21) of the secondary coil (7) there.

13. Placement unit (1) for populating a substrate with components, having a first magnetic core (4), wound with a primary coil (3), which is electrically connected to a voltage source (9) assigned to the automatic placement unit (1), wherein the first magnetic core (4) is arranged such that it can be coupled to a second magnetic core (8), wound with a secondary coil (7), assigned to a feeding unit (5) for components, and the first magnetic core (4) is elastically mounted relative to the placement unit (1) by means of two helical springs (19), so that in the coupled state the first magnetic core (4) is pressed against the second magnetic core (8), and the contact surfaces of the magnetic cores facing toward each other rest securely in contact with each other without a gap, wherein the first magnetic core (4) is additionally rotatably mounted by means of the two helical springs (19), so that contact surfaces of the first and second magnetic cores (4, 8) facing each other are parallel to each other in the pressed-on state.

14. Placement unit (1) according to claim 13,
**characterized in that**
the first magnetic core (4) is designed so narrow that it does not exceed the width of the feeding unit (5) and that in areas where it is wound with the primary coil (3), together with the primary coil (3), it does not exceed the width of the feeding unit (5).

15. Placement unit (1) according to claim 14,
**characterized in that**
the first magnetic core (4) has an E-shape, the central arm (15) of which is wound with the primary coil (3).

16. Placement unit (1) according to claim 15,
**characterized in that**
the rear part (20) of the second magnetic core (4) connecting the three arms, at least in the area of the extension of the central arm (15), is designed so narrow that, on at least one side of the first magnetic core (4), it terminates flush with the central arm (15) in order to pass connecting cables of the primary coil (3) there.

## Revendications

1. Dispositif de transfert d'énergie par induction entre une unité de placement de composants (1) et une unité de fourniture de composants (5), avec
- un premier noyau magnétique (4) enveloppé avec une bobine primaire (3), qui est affecté à l'unité de placement (1),
- un deuxième noyau magnétique (8) enveloppé avec une bobine secondaire (7), qui est affecté à l'unité de fourniture (5) et couplé au premier noyau magnétique (4),
au moins soit le premier noyau magnétique (4) vis-à-vis de l'unité de placement (1) soit le deuxième noyau magnétique (8) vis-à-vis de l'unité de fourniture (5) étant logé de manière faisant ressort par deux ressorts hélicoïdaux (19) de telle manière qu'il est appuyé respectivement contre l'autre noyau magnétique et les surfaces de contact des noyaux magnétiques, tournées l'une vers l'autre, sont situées fermement l'une contre l'autre sans interstice, le noyau magnétique logé de façon faisant ressort étant logé en plus de façon pivotable par les deux ressorts hélicoïdaux (19) de sorte que les surfaces de contact tournées l'une vers l'autre des premier et deuxième noyaux magnétiques (4,8) sont, à l'état appuyé, situées parallèlement l'une contre l'autre.

2. Dispositif selon la revendication 1, **caractérisé en ce que** le deuxième noyau magnétique (8) est exécuté si étroit qu'il ne dépasse pas la largeur de l'unité de fourniture (5) et **en ce que** dans les zones où il est enveloppé avec la deuxième bobine secondaire (7), il ne dépasse pas avec la bobine secondaire (7) la largeur de l'unité de fourniture (5).

3. Dispositif selon l'une quelconque des revendications 1 à 2, **caractérisé en ce que** le premier noyau magnétique (4) est exécuté si étroit qu'il ne dépasse pas la largeur de l'unité de fourniture (5) et **en ce que** dans les zones où il est enveloppé avec la bobine primaire (3), il ne dépasse pas avec la bobine primaire (3) la largeur de l'unité de fourniture (5).

4. Dispositif selon l'une quelconque des revendications 1 à 3, **caractérisé en ce que** le deuxième noyau magnétique (8) présente une structure de forme E, seule la branche centrale (15) étant enveloppée avec la bobine secondaire (7).

5. Dispositif selon la revendication 4, **caractérisé en ce que** le premier noyau magnétique (4) présente une structure en forme de E, seule la branche centrale (15) étant enveloppée avec la bobine primaire (3) et le premier et le deuxième noyau magnétiques (4,8) à l'état appuyé se touchent respectivement sur les surfaces frontales libres des trois branches.

6. Dispositif selon la revendication 4, **caractérisé en ce que** la partie arrière (20) du deuxième noyau magnétique (8), reliant les trois branches, est constituée au moins dans la zone de la prolongation de la branche centrale (15) si étroite qu'elle obture au moins sur un côté du deuxième noyau magnétique (8) en venant affleurer la branche centrale (15) pour guider à cet endroit des lignes de connexion (21) de la bobine secondaire (7).

7. Dispositif selon la revendication 5, **caractérisé en ce que** la partie arrière (20) du premier noyau magnétique (4), reliant les trois branches, est constituée, au moins dans la zone de la prolongation de la branche centrale (15), si étroite qu'elle obture au moins sur un côté du premier noyau magnétique (4) en venant affleurer la branche centrale (15) pour guider à cet endroit des lignes de connexion (21) de la bobine primaire (3).

8. Dispositif selon l'une quelconque des revendications 1 à 7, **caractérisé en ce que** la bobine primaire (3) est reliée électriquement à une source de tension (9) affectée à l'unité de placement (1) et la bobine secondaire (7) à un consommateur (10) affecté à l'unité de fourniture (5).

9. Unité de fourniture (5) pour composants pour une unité de placement (1), avec un boîtier de système de fourniture (11), un deuxième noyau magnétique (8), qui est enveloppé avec une bobine secondaire (7) qui est reliée électriquement à un consommateur (10) affecté à l'unité de fourniture (5), le deuxième noyau magnétique (8) étant disposé de telle manière qu'il peut être couplé avec un premier noyau magnétique (4) affecté à l'unité de placement (1), qui est enveloppé avec une bobine primaire (3), et le deuxième noyau magnétique (8) est logé en face de l'unité de fourniture (5) par deux ressorts hélicoïdaux (19) de sorte que le deuxième noyau magnétique (8) est appuyé à l'état accouplé contre le premier noyau magnétique (4) et les surfaces de contact des noyaux magnétiques, tournées l'une vers l'autre, sont situées fermement l'une contre l'autre sans interstice, le deuxième noyau magnétique (8) étant logé en plus de façon pivotable par les deux ressorts hélicoïdaux (19) de sorte que les surfaces de contact tournées l'une vers l'autre des premier et deuxième noyaux magnétiques (4,8) sont, à l'état appuyé, situées l'une contre l'autre parallèlement.

10. Unité de fourniture (5) selon la revendication 9, **caractérisée en ce que** le deuxième noyau magnétique (8) est exécuté si étroit qu'il ne dépasse pas la largeur du boîtier de système de fourniture (11) et **en ce qu'**il ne dépasse pas la largeur du boîtier de système de fourniture (11) avec la bobine secondaire (7) dans les zones où il est enveloppé avec la bobine secondaire (7).

11. Unité de fourniture (5) selon la revendication 10, **caractérisée en ce que** le deuxième noyau magnétique (8) présente une structure en forme de E dont la branche centrale (15) est enveloppée par la bobine secondaire (7).

12. Unité de fourniture (5) selon la revendication 11, **caractérisée en ce que** la partie arrière (20) du deuxième noyau magnétique (8), reliant les trois branches est constituée au moins dans la zone de la prolongation de la branche centrale (15) si étroite qu'elle obture au moins sur un côté du deuxième noyau magnétique (8) en venant affleurer la branche centrale (15) pour guider à cet endroit des lignes de connexion (21) de la bobine secondaire (7).

13. Unité de placement (1) pour équiper un substrat de composants, avec un premier noyau magnétique (4), qui est enveloppé avec une bobine primaire (3) qui est électriquement reliée à une source de tension (9) affectée à l'unité de placement (1), le premier noyau magnétique (4) étant disposé de telle manière qu'il peut être couplé avec un deuxième noyau magnétique (8) affecté à une unité de fourniture (5) pour composants, qui est enveloppé avec une bobine secondaire (7), et le premier noyau magnétique (4) étant logé de façon faisant ressort en face de l'unité de placement (1) par deux ressorts hélicoïdaux (19) de telle manière que le premier noyau magnétique (4) est appuyé à l'état couplé contre le deuxième noyau magnétique (8) et les surfaces de contact des noyaux magnétiques, tournées l'une vers l'autre, sont situées fermement l'une contre l'autre sans interstice, le premier noyau magnétique (4) étant logé en plus de façon pivotable par les deux ressorts hélicoïdaux (19) de sorte que les surfaces de contact tournées l'une vers l'autre des premier et deuxième noyaux magnétiques (4,8) sont, à l'état appuyé, situées parallèlement l'une contre l'autre.

14. Unité de placement (1) selon la revendication 13, **caractérisée en ce que** le premier noyau magnétique (4) est exécuté si étroit qu'il ne dépasse pas la largeur de l'unité de fourniture (5) et **en ce que** dans les zones où il est enveloppé avec la bobine primaire (3), il ne dépasse pas avec la bobine primaire (3) la largeur de l'unité de fourniture (5).

15. Unité de placement (1) selon la revendication 14, **caractérisée en ce que** le premier noyau magnétique (4) présente une structure en forme de E, dont la branche centrale (15) est enveloppée par la bobine primaire (3).

16. Unité de placement (1) selon la revendication 15, **caractérisée en ce que** la partie arrière (20) du premier noyau magnétique (4), reliant les trois branches, est constituée, au moins dans la zone de la prolongation de la branche centrale (15), si étroite qu'elle obture au moins sur un côté du premier noyau magnétique (4) en venant affleurer la branche centrale (15) pour guider à cet endroit des lignes de connexion de la bobine primaire (3).
